# EUROPEAN PATENT APPLICATION

(11) **EP 1 022 935 A1**
(43) Date of publication of application: **26.07.2000**
(21) Application number: 99300331.8
(22) Date of filing: 19.01.1999
(51) Int. Cl.: H05K 7/14

(54) **Bridge board for compact cabinet board**

(71) Applicant: LUCENT TECHNOLOGIES INC., Murray Hill, New Jersey 07974-0636 (US)
(72) Inventor: Horton, Jeremy David, Tetbury,Glos. GL8 8EY (GB)
(74) Representative: Williams, David John

(57) **Abstract**

There is described a bridge board for connecting a cabinet board to a back-plane of a cabinet. The cabinet board has a connector for connection to a connector of the back plane of the cabinet. The bridge board and the cabinet board each have a height and width dimension corresponding to a slot in the cabinet for receiving a board for connection to the back-plane of the cabinet. The cabinet board has a depth shorter than the depth of the slot. The bridge board has a board connector for connection to the cabinet board connector and a back-plane connector for connection to the connector of the back-plane. The depth of the bridge board is such that the combined depth of the bridge board and the cabinet board correspond to a required depth for the slot.

## Description

### Field of the Invention

The present invention relates to the installation of circuit boards mounted into slots provided on shelves of cabinet units, and particularly such circuit boards that have a depth that is shorter than the depth of the slot of the cabinet.

### Background to the Invention

Cabinets for rack mounted circuit boards are well known. The cabinet is provided with a back plane having a number of connectors for connection to circuit boards. Circuit boards are mounted into the cabinet on slots provided on shelves within the cabinet. The circuit boards have connectors to connect with the connectors on the back plane of the cabinet. In this way a number of circuit boards can be mounted into the cabinet, all of which are connected to the system via a common back plane bus.

One of the features of such a cabinet arrangement is that the circuit boards are mounted in slots such that they can slide into the cabinet to make the connection with the connector on the back plane. Once connected in position, the circuit boards have a front-end aligned with the front edge of the cabinet so that they can be readily removed if necessary. The boards may be removed during maintenance, fault testing etc.

To ensure the boards can be removed, it is essential that the front-edges of the boards align with, or are close to, the edge of the cabinet. The boards normally have to fit flush with the front edge of the cabinet so that any locking mechanism can engage, for example so that the boards can be clamped or bolted in. Thus for a given cabinet, boards must have a given depth, or length, to be installed in the cabinet, as well as a standard height and width. The dimensions of a board for a given application will be determined by the standard around which the system is built.

There are situations were it may be advantageous to use a circuit board from one standard in another standard. However, because of the incompatibility of the board design this is in impractical. There may be instances were the height and width of boards from two different standards are the same, but the length of one is different to the other. The short board cannot be used in one standard because it would be too small to extend down the slot, and the long board could not be used in the other standard because it would stick out of the cabinet.

This may lead to inefficient usage of circuitry. If a board from one standard provides a useful function in another standard, then an off-the-shelf piece of equipment is provided. However if the physical length of the board alone means that it cannot be used in one standard, then a board having the same functionality, but different physical length, needs to be manufactured which increase costs and leads to reduced utilisation of technology.

For example, in the personal computer industry there is a standard bus architecture known as PCI (personal computer interface). The bus architecture defines the signals on the back plane, and consequently the connector configurations on the back plane. The cabinets for the PCI standard are then built to a common standard so that different manufacturers can manufacture different boards for use in any PCI system. Thus the size of the boards used is dictated by the standard.

A more robust version of the PCI standard has been developed for use in the telecommunications industry, and is known as CPCI (compact personal computer interface). CPCI has a standardised shelf for the installation of boards as well. The circuit boards may be single board computers, input/output boards, etc.

Lucent Technologies manufactures a product known as BCF. Part of this product includes a cabinet that has a slot opening having the same height and width as the CPCI standard, but the slot length (or depth) is much longer. The connectors on the back plane of the cabinet are also compatible with the CPCI standard. This means that CPCI boards cannot be used simply because they are too short to fit into the cabinet.

It is therefore an object of the present invention to provide a solution to the incompatibility of boards between different standards caused by different board lengths.

### Summary of the Invention

According to the present invention there is provided a bridge board for connecting a cabinet board to a back-plane of a cabinet, the cabinet board having a connector for connection to a connector of the back-plane of the cabinet, wherein the bridge board and the cabinet board each have a height and width dimension corresponding to a slot in the cabinet for receiving a board for connection to the back-plane of the cabinet, and the cabinet board has a depth shorter than depth of the slot, wherein the bridge board has a board connector for connection to the cabinet board connector and a back-plane connector for connection to the connector of the back-plane, the depth of the bridge board being such that the combined depth of the bridge board and the cabinet board correspond to a required depth for the slot.

The bridge board may include connections thereon such that the pin connections of the board connector of the bridge board are mapped to the pin connections of the back-plane connector of the bridge board.

The bridge board may further include functional connected to the board connector of the bridge board.

The connector of the back plane may not be compatible with the connector of the cabinet board.

### Brief Description of the Drawings

Figure 1 illustrates a simplified layout of a cabinet for receiving circuit boards on slots;
Figure 2 illustrates a circuit board of a first standard suitable for mounting in slots of the cabinet of Figure 1;
Figure 3 illustrates a circuit board of a second standard having the same dimensions as the circuit board of Figure 2, but a shorter length;
Figure 4 illustrates a bridge board according to the present invention for interfacing with the circuit board of Figure 3;
Figure 5 illustrates a first preferred embodiment of the bridge board of Figure 4; and
Figure 6 illustrates a second preferred embodiment of the bridge board of Figure 4.

### Description of Preferred Embodiments

None of the drawings herein are drawn to scale, and they are all presented in a way that best illustrates the principles of the present invention.

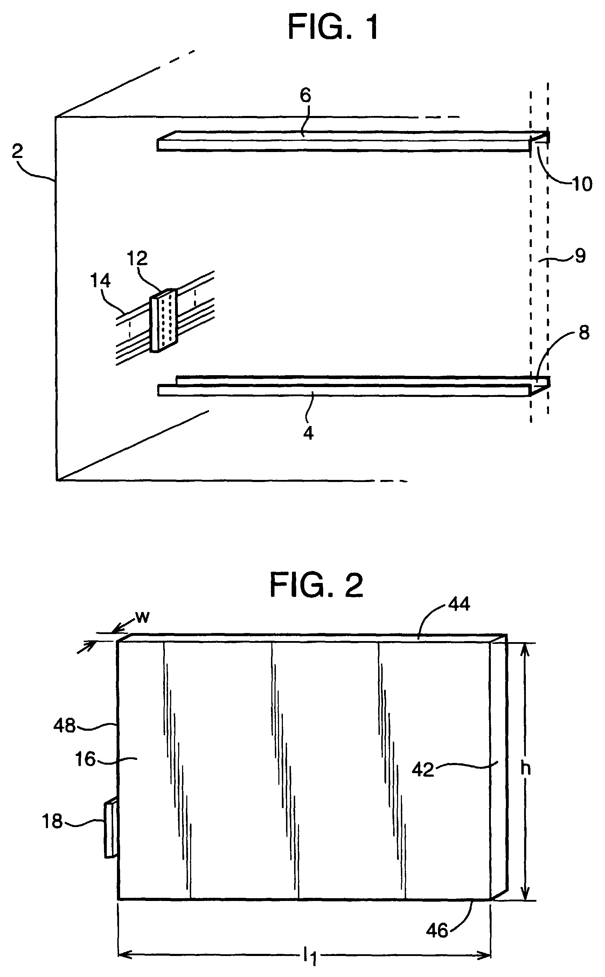

Referring to Figure 1 there is illustrated a simplified construction of a cabinet for receiving circuit boards. The cabinet is generally represented by reference numeral 2. It will be appreciated that the cabinet is enclosed, with a door presented at a front end to access the area for mounting the circuit boards.

It can be seen that the cabinet is provided with a lower slot 4 and an upper slot 6, each with a respective groove 8 and 10 for receiving a circuit board.

The lower and upper slots 8 and 10 form a slot opening 9 for receiving a circuit board. The cabinet will in fact contain a plurality of pairs of lower and upper slots for receiving a plurality of circuit boards.

The back plane of the cabinet includes a connector 12 connected to wires 14 forming a back plane bus. The connector 14 is for connection to a circuit board mounted into the slots 4 and 6. The back plane is provided with a plurality of connectors 12 corresponding to the number of pairs of slots in the cabinet for receiving circuit boards. It will also be appreciated that there may be more than one connector 12 associated with each slot.

Figure 2 illustrates a circuit board suitable for mounting in the cabinet 2 of Figure 1. The circuit board 16 has a rear end 48 for connection with the back plane of the cabinet. A connector 18 is mounted on the rear end 48 for connection to the connector 12 on the back plane of the cabinet. It will be appreciated that the rear end of the circuit board 16 may be provided with additional connectors for connection to additional connectors on the back plane associated with the slot opening 9.

A front end 42 of the circuit board 16 is flush with the slot opening 9 when the circuit board is mounted in the cabinet. The circuit board has a top edge 44 which fits the upper slot 10, and a bottom edge 46 which fits the lower slot 4.

The height h of the circuit board corresponds to the distance between the upper and lower slots, the width w of the circuit board corresponds to the width of the slots 4 and 6, and the length (or depth) l₁ of the circuit board corresponds to the length of the slots 4 and 6.

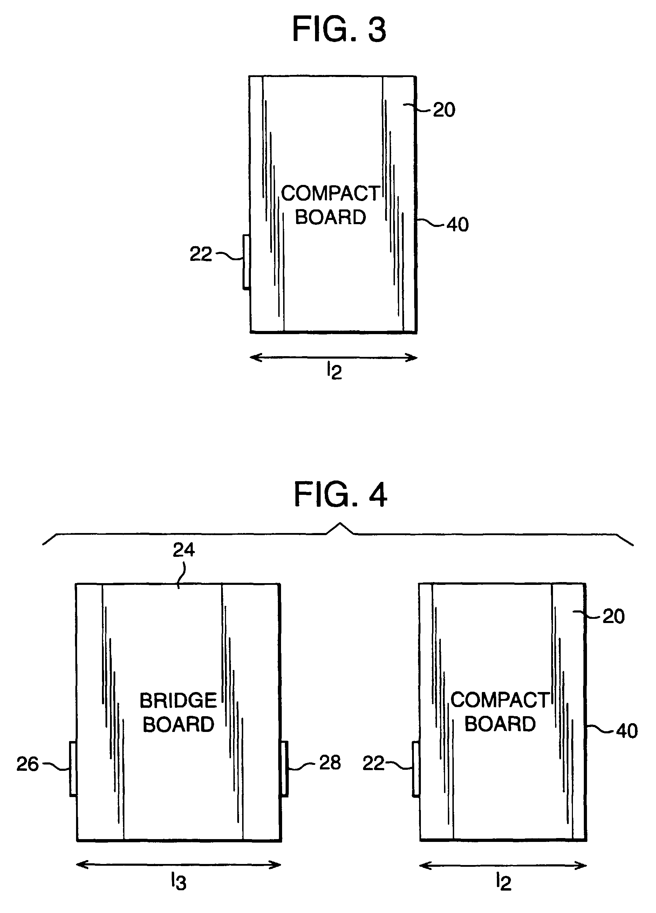

Referring to Figure 3, there is shown a compact circuit board 20, which has a width w and height h corresponding to those of the circuit board 16, but a length l₂ shorter than the length l₁. The compact circuit board has a connector 22 which corresponds to the connector 18 of the full size circuit board 16, and is compatible with the connector 12 of the cabinet 2.

The compact circuit board is dimensioned such that it can fit into the slots 4 and 6 of the cabinet, but the length of the compact circuit board would mean that it's front end would not be flush with, or even close to the front end of the cabinet. This would make it difficulty to properly push the compact circuit board into position to make contact with the connector 12 if there were other full length circuit boards adjacent thereto, and would similarly make it difficult to remove the compact circuit board from the cabinet.

Thus, according to the present invention, a bridge board 24 as shown in Figure 4 is provided. The bridge board has the same height h and width w as the full size circuit board of Figure 2, and has length l₃. The bridge board 28 has a connector 28 for connection to the connector 22 of the compact circuit board 20, and a connector 26 for connection to the connector 12 on the back plane of the cabinet.

The length l₃ of the bridge board 24 is such that the combination of the bridge board and the compact circuit board (having length l₂) correspond to the length provided by the slots 4 and 6 (i.e. length l₁). That is, the compact circuit board is plugged into the bridge board 24 by connection of the connectors 22 and 28, and the bridge board is plugged into the back plane of the cabinet by connection of the connectors 26 and 28, such that the combined lengths l2 and l3 result in the front side of the compact circuit board being flush with the front of the cabinet.

Although the connectors 22, 26, and 28 are illustrated protruding from the boards, it will be appreciated that these connectors are mounted on the boards such that, for example, when the connectors 22 and 28 are connected together, the opposing edges of the bridge board 24 and compact board 20 may be in contact. The opposing edges do not, however, have to be in contact.

In this simple example, the connector 22 of the compact circuit board is compatible with the connector 12 of the back plane, and the bridge board therefore provides extra length to enable the compact circuit board 20 to be used in the cabinet 2. However, it will be appreciated that if the connector 22 is not compatible with the connector 12, then the bridge board can also act as an interface. That is the bridge board can be provided with a connector 28 of a first type compatible with the connector 22 of the compact circuit board. The bridge board 24 can then also be provided with a connector 26 of a second type compatible with the connector 12 of the back plane.

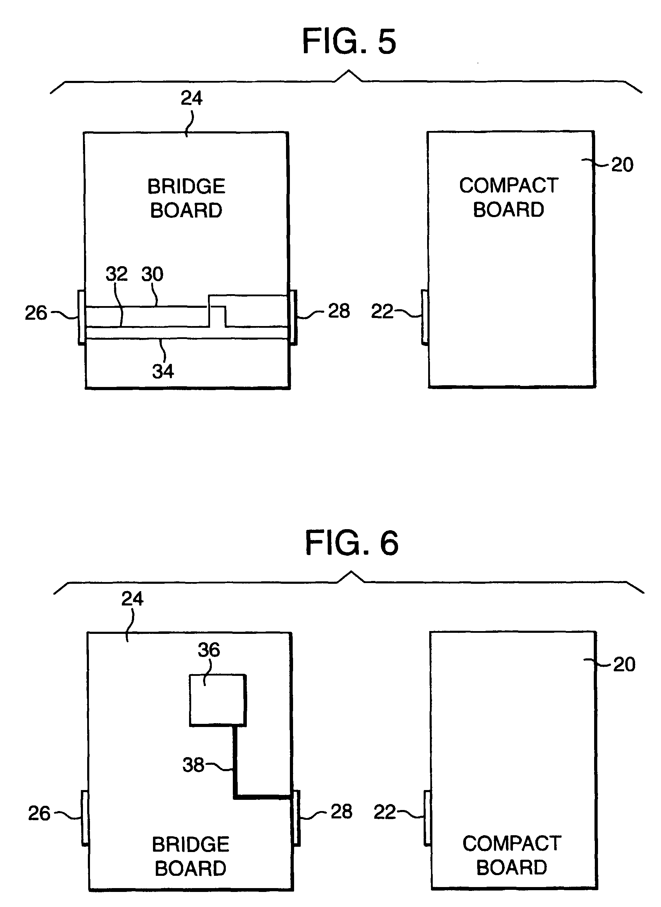

In the simple example of Figure 4 the connector 28 may be wired by the bridge board on a direct pin-to-pin basis to the connector 26, such that the connector 22 is connected on a pin-to-pin basis to the connector 12. In a more sophisticated arrangement, the connector 28 may be connected to the connector 26 in a cross-wired fashion, as exemplified in Figure 5.

Figure 5 illustrates three of the connections 30, 32, and 34 between the connectors 26 and 28. As illustrated in Figure 5, the connection 34 is a direct pi-to-pin connection, whilst connections 30 and 32 map pins from connector 26 to different pins of connector 28. Thus, where appropriate, the bridge board can be used to map signal connections on the connector 22 to signal connections on the connector 12 on a basis other than a direct pin-to-pin basis. This feature may be useful in the example described above where the connector 22 is not compatible with the connector 12.

Finally, as shown in Figure 6, the bridge board 24 may be utilised by the compact circuit board 20 to introduce additional functionality. As illustrated in Figure 6, the bridge board is provided with additional functional circuitry 36, such as a digital signal processor (DSP), which can be accessed by the compact circuit board. A plurality of connections 38 connects to the functional circuit 36 from the connector 28. This enables the compact circuit board to access the functional circuitry via the connectors 22 and 28. The connections 38 may be provided from normally unused pins of the connector 22.

It will be appreciated that whilst ideally the combined length of the bridge board 24 and compact circuit board 20 will correspond to the length of the full-size circuit board by designing the length 13 of the bridge board accordingly, there will ba a tolerance allowed in such length. However, there will be a minimum extra length which the bridge board is required to introduce to ensure that the compact circuit board can be used in the longer slot.

## Claims

1. A bridge board for connecting a cabinet board to a back-plane of a cabinet, the cabinet board having a connector for connection to a connector of the back-plane of the cabinet, wherein the bridge board and the cabinet board each have a height and width dimension corresponding to a slot in the cabinet for receiving a board for connection to the back-plane of the cabinet, and the cabinet board has a depth shorter than depth of the slot, wherein the bridge board has a board connector for connection to the cabinet board connector and a back-plane connector for connection to the connector of the back-plane, the depth of the bridge board being such that the combined depth of the bridge board and the cabinet board correspond to a required depth for the slot.

2. The bridge board of claim 1, wherein the bridge board includes connections thereon such that the pin connections of the board connector of the bridge board are mapped to the pin connections of the back-plane connector of the bridge board.

3. The bridge board of claim 1 or claim 2 further including functional circuitry connected to the board connector of the bridge board.

4. The bridge board of any one of claims 1 to 3, wherein the connector of the back plane is not compatible with the connector of the cabinet board.
